# EUROPÄISCHE PATENTSCHRIFT

(11) **EP 3 241 261 B1**
(45) Veröffentlichungstag und Bekanntmachung des Hinweises auf die Patenterteilung: **15.04.2020**
(21) Anmeldenummer: 15820820.7
(22) Anmeldetag: 02.12.2015
(51) Int. Cl.: H01T 4/04, H01R 9/26, H01T 4/06

(54) **ÜBERSPANNUNGSSCHUTZANORDNUNG FÜR DIE INFORMATIONS- UND TELEKOMMUNIKATIONSTECHNIK**
OVERVOLTAGE PROTECTION ARRANGEMENT FOR INFORMATION AND TELECOMMUNICATION TECHNOLOGY
DISPOSITIF DE PROTECTION CONTRE DES SURTENSIONS POUR LA TECHNIQUE DES INFORMATIONS ET DES TÉLÉCOMMUNICATIONS

(30) Priorität: 29.12.2014 DE 102014019560; 24.07.2015 DE 102015009564
(43) Veröffentlichungstag der Anmeldung: 08.11.2017
(73) Patentinhaber: DEHN SE + Co KG, 92318 Neumarkt / Opf. (DE)
(72) Erfinder: IGL, Peter, 90602 Pyrbaum (DE); SCHRAFL, Julius, Maria, 92318 Neumarkt (DE)
(74) Vertreter: Kruspig, Volkmar
(86) Internationale Anmeldenummer: PCT/EP2015/078265
(87) Internationale Veröffentlichungsnummer: WO 2016/107713

(56) Entgegenhaltungen:
- DE-A1-102006 034 164
- KR-B1- 101 277 321
- US-A- 4 922 374
- US-A1- 2004 246 644

## Beschreibung

Die Erfindung betrifft eine Überspannungsschutzanordnung für die Informations- und Telekommunikationstechnik, bestehend aus einem Gehäuse mit am Gehäuseboden ausgebildeten Mitteln zur Hutschienenmontage, im Gehäuse befindlichen Überspannungsschutzelementen, elektrischen Anschlussmitteln sowie mindestens einer Leiterplatte als Verdrahtungsträger für die Überspannungsschutzelemente, weiterhin bestehend aus einem Gehäuse mit einem balkenförmigen Grundkörper und einem hervorspringenden Kopfteil gemäß Anspruch 1.

Überspannungsschutzanordnungen für die Informationstechnik, z.B. als teilbarer Ableiter für die Hutschienenmontage, sind unter der Produktbezeichnung Blitzductor, hergestellt und angeboten von der Firma DEHN + SÖHNE GmbH + Co. KG, bekannt.

Zum wirtschaftlichen Schutz von mehradrigen Signalwegen gehören Überspannungsableiter zum bekannten Stand der Technik, die in einem Gehäuse befindlich sind, das eine Hutschienenmontage gestattet. Dabei befinden sich in dem Gehäuse, das die Gestalt eines auf dem Kopf stehenden T besitzt, die eigentlichen Überspannungsschutzelemente, Entkopplungswiderstände, Dioden, Induktivitäten, aber auch bei Notwendigkeit Ansteuerschaltungen. Der Anschluss eingangs- und ausgangsseitig erfolgt wie beispielsweise bei den Typen Blitzductor BVT über Schraubklemmen, die von der Oberseite des balkenförmigen Grundkörpers des Gehäuses zugänglich sind.

Aus der DE 20 2011 000 835 U1 ist ein busfähiges, anreihbares Anschluss- und/oder Funktionsmodul zur Steuerung und/oder Überwachung technischer Prozesse oder zur Gebäudeautomatisierung vorbekannt, das einen scheiben- oder blockartigen Aufbau besitzt. Dieses vorbekannte Funktionsmodul kann mit weiteren Modulen zu einem Anschlusssystem zusammengestellt werden und weist mindestens einen Basisklemmenkörper und ein aufsetzbares Gehäuse auf. Im Gehäuse befinden sich eine Leiterplatte und/oder ein Stanzgitter bzw. bei einer Ausführungsform eine Stromschienenanordnung. Darüber hinaus ist wenigsten ein Busleiterkontakt zur Weiterleitung wenigstens eines Energie- oder Datenbusses in Anreihrichtung vorhanden. Am Gehäuse nach DE 20 2011 000 835 U1 können Anschluss- oder Funktionsbausteine separat angeschlossen werden, wobei mindestens einer dieser Funktionsbausteine eine Signalanpassungselektronik zusätzlich zu einer I/O-Elektronik des entsprechenden Anschluss- oder Funktionsmoduls besitzt. Wenigstens eines der anreihbaren Anschluss- oder Funktionsmodule soll eine Anschlussebene besitzen, deren Anschlüsse derart leitend miteinander verbunden sind, dass eine Reihenklemmenfunktion realisierbar ist.

Es hat sich gezeigt, dass bei den bekannten Überspannungsschutzanordnungen für die Informations- und Telekommunikationstechnik der Anschluss der zu schützenden Geräte über vorhandene Drahtklemmen einen erheblichen Aufwand darstellt, wobei oftmals die Zahl der anzuschließenden Drähte eine Vielzahl von Schraubklemmen erfordert, die nur schlecht in ein entsprechendes Gehäuse integriert werden kann. Bei der Notwendigkeit einer Durchverbindung einer Bus-/Kommunikationsleitung für den Datenaustausch zwischen mehreren, nebeneinander angeordneten Geräten war es im Bereich des Überspannungsschutzes bisher notwendig, eine diesbezüglich separate Kabelverbindung auszuführen. Beim Austausch entsprechender Geräte bzw. zu Mess- und Prüfvorgängen ist es dadurch erforderlich, weitere Klemmen zu lösen mit der Folge einer aufwendigeren Handhabung.

Aus dem Vorgenannten ist es daher Aufgabe der Erfindung, eine weiterentwickelte Überspannungsschutzanordnung für die Informations- und Telekommunikationstechnik, bestehend aus einem Gehäuse mit am Gehäuseboden ausgebildeten Mitteln zur Hutschienenmontage und im Gehäuse befindlichen Überspannungsschutzelementen nebst elektrischen Anschlussmitteln anzugeben, welche zum einen einen optimalen Bauraum für die erforderlichen elektrischen und mechanischen Mittel zur Verfügung stellt und die darüber hinaus neue Möglichkeiten zur Kontaktierung bietet, so dass insgesamt der Handhabungs- und Montageaufwand beim Einsatz derartiger Überspannungsschutzanordnungen bzw. -geräte reduziert ist.

Die Lösung der Aufgabe der Erfindung erfolgt mit der Merkmalskombination nach Anspruch 1, wobei die Unteransprüche mindestens zweckmäßige Ausgestaltungen und Weiterbildungen darstellen.

Es wird demnach von einer Überspannungsschutzanordnung für die Informations- und Telekommunikationstechnik ausgegangen. Hierunter sind alle Applikationen auch im Bereich der Gebäudetechnik, der Prozesstechnik und der elektronischen Datenübertragung zu verstehen, ohne dass andere Anwendungsbereiche ausgeschlossen werden sollen.

Die Überspannungsschutzanordnung umfasst ein Gehäuse mit am Gehäuseboden ausgebildeten Mitteln zur Hutschienenmontage.

Darüber hinaus befinden sich im Gehäuse die eigentlichen Überspannungsschutzelemente, z.B. Varistoren, Gasableiter, Schutzdioden, Widerstände oder dergleichen. Am bzw. im Gehäuse sind elektrische Anschlussmittel vorhanden und es ist mindestens eine Leiterplatte als Verdrahtungsträger für die Überspannungsschutzelemente vorgesehen.

Das Gehäuse weist z.B. eine Seitenansicht auf, die der Gestalt eines angenäherten, auf dem Kopf stehenden T entspricht. Abwandlungen dieser Gehäuseform liegen im Sinne der Erfindung.

Das Gehäuse besitzt einen im Wesentlichen balkenförmigen Grundkörper und einen vom Grundkörper vorspringenden Kopfteil, wobei die elektrischen Anschlussmittel z.B. über die Oberseite oder Vorderseite des balkenförmigen Grundkörpers zugänglich sind oder betätigt werden können.

Erfindungsgemäß ist eine erste und eine zweite Leiterplatte ausgebildet, die voneinander beabstandet jeweils an den Innenseiten der Seitenwände des Gehäuses befindlich sind.

Der sich ergebende Abstandsraum zwischen den Leiterplatten bildet ein Raumvolumen für die elektrischen Anschlussmittel in Form von elektrischen Anschlussklemmen, Anschlussbuchsen und/oder Anschlusssteckern. Erste Anschlussmittel sind in horizontaler und zweite Anschlussmittel in vertikaler Ebene des balkenförmigen Grundkörpers zugänglich. Weiterhin entspricht die Flächenform der Leiterplatten der Form des Gehäuses bzw. ist dieser Gehäuseform angenähert. Damit wird quasi die größtmögliche Fläche, die sich durch die Gehäusegestalt ergibt, durch die Leiterplatten ausgenutzt.

Die beabstandete Anordnung der Leiterplatten ermöglicht es, unmittelbar mit den Leiterplatten kontaktiert, erforderliche Klemmen für einen Drahtanschluss, aber auch koaxiale Steckverbinder zu fixieren und elektrisch zu kontaktieren.

Erfindungsgemäß sind die ersten Anschlussmittel als auf den Leiterplatten fixierte, verriegelbare Buchsenleisten zum Klemmen von Drähten ausgebildet.

Bei einer weiteren Ausführungsform sind die zweiten Anschlussmittel als koaxiale Stecker oder Buchsen ausgeführt.

Bei einer bevorzugten Weiterbildung der Erfindung ist die horizontale Ebene des balkenförmigen Grundkörpers mindestens im Bereich der Anschlussmittel als Schrägfläche zur abgewinkelten Führung und Aufnahme von Anschlussdrähten bei Anordnung des Überspannungsschutzgeräts unter einer Verteilerabdeckung ausgebildet.

Die erfindungsgemäße Überspannungsschutzanordnung ist aneinanderreihbar ausgebildet.

Diesbezüglich ist am Kopfteil des jeweiligen Gehäuses jeweils im Bereich der Leiterplatten eine verschließbare Öffnung vorgesehen, welche Zugang zu einem Leiterplattenabschnitt, insbesondere zu einem Leiterplattenzug gewährt. Bei mindestens zwei aneinandergereihten Überspannungsschutzgeräten ist mittels der Öffnungen ein Steckelement anbringbar, welches die jeweiligen Geräte mechanisch und/oder elektrisch verbindet.

Das Steckelement ist als Formteil realisiert, welches jeweils einen auf die Öffnungskontur abgestellten, dieser komplementären Fortsatz aufweist.

Das Steckelement selbst kann leitfähig sein oder einen leitfähigen Abschnitt besitzen, um die gewünschte elektrische Verbindung, z.B. für ein Bussystem zu schaffen. Insofern ist das Steckelement als elektrische Verbindungsbrücke ausführbar.

Im Bereich der dem Gehäuseboden zugewandten Enden der Leiterplatten sind diese über ein gemeinsames Kontaktelement mechanisch und elektrisch verbunden, wobei über das gemeinsame Kontaktelement eine elektrische Verbindung zur Hutschiene zum Zweck der Schaffung einer Erdverbindung herstellbar ist.

Die Erfindung soll nachstehend anhand von Ausführungsbeispielen und unter Zuhilfenahme von Figuren näher erläutert werden.

Hierbei zeigen:
- Fig. 1: eine perspektivische Darstellung der Überspannungsschutzanordnung mit Gehäuse in Gestalt eines auf dem Kopf stehenden T;
- Fig. 2: eine Darstellung ähnlich derjenigen nach Fig. 1, jedoch mit frei zugänglichem Blick auf die die Gehäuseform approximierenden, beabstandeten Leiterplatten nebst Anschlussmitteln;
- Fig. 3: eine Darstellung von drei aneinandergereihten Überspannungsschutzanordnungen (unter Weglassung von Teilen des Gehäuses);
- Fig. 4: eine vergrößerte Darstellung des als Verbindungsbrücke ausgebildeten Steckelements, welches bereits bei der Fig. 3 erkennbar ist;

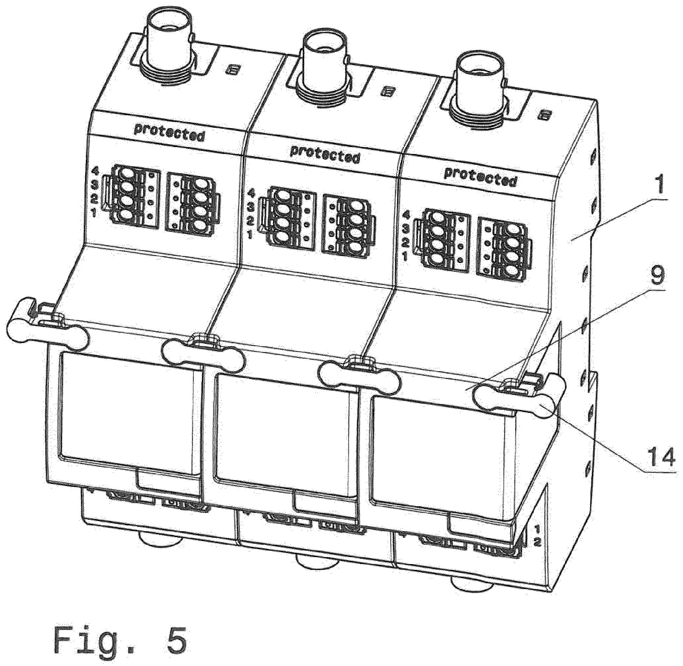

- Fig. 5: eine perspektivische Darstellung (Ansicht von oben) von drei aneinandergereihten Überspannungsschutzanordnungen, die über Steckelemente verbunden sind;

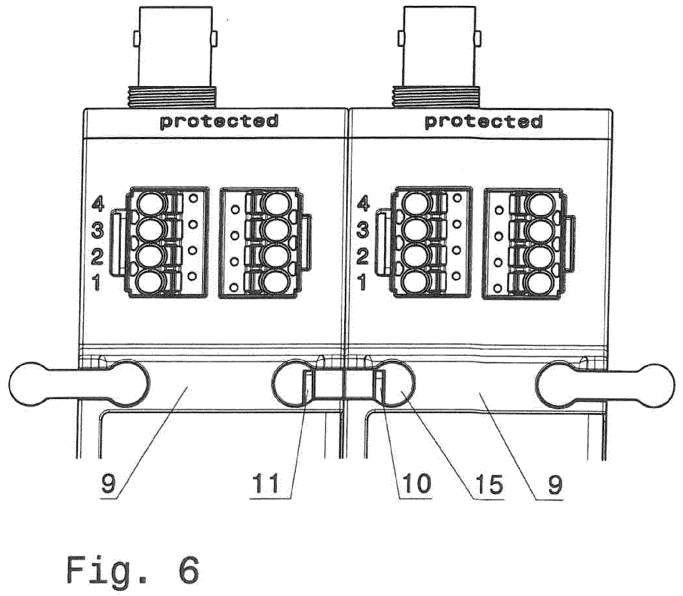

- Fig. 6: eine Detaildarstellung zweier aneinandergereihter Überspannungsschutzanordnungen mit im Kopfteil des Gehäuses jeweils befindlicher verschließbarer Öffnung und im Öffnungsabschnitt erkennbarem Teil einer jeweiligen Leiterplatte;
- Fig. 7: eine perspektivische Darstellung der Anordnung eines Überspannungsschutzgeräts auf einer Hutschiene mit teilweggebrochenem Gehäuse und

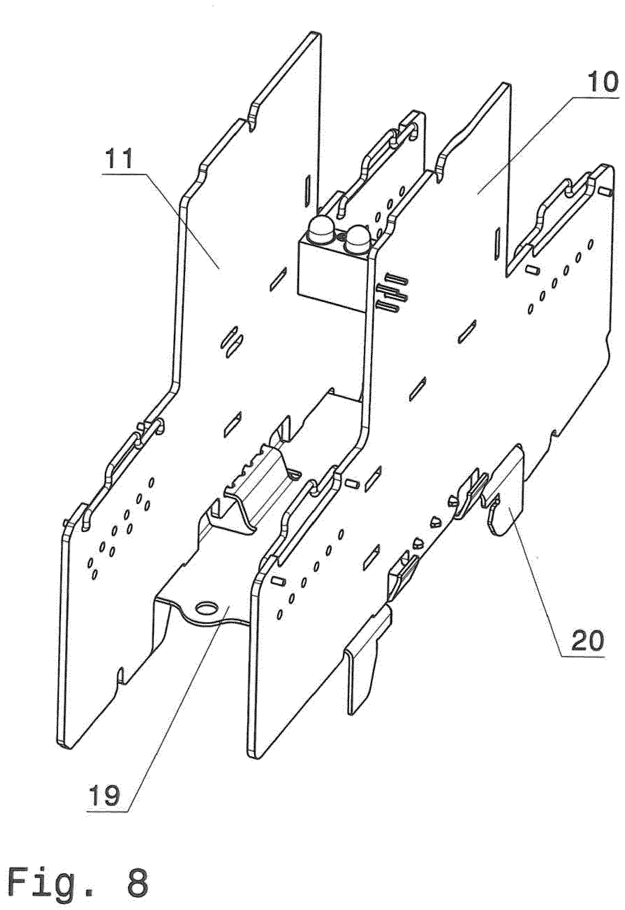

- Fig. 8: eine Detaildarstellung der Leiterplatten mit gemeinsamem Kontaktelement.

Gemäß Ausführungsbeispiel wird von einer Überspannungsschutzanordnung ausgegangen, die ein Gehäuse besitzt, das die Gestalt eines auf dem Kopf stehenden T besitzt. Das Gehäuse besitzt einen balkenförmigen Grundkörper 1 und einen hervorspringenden Kopfteil 2.

Am Boden des balkenförmigen Grundkörpers 1 ist ein Rücksprung 3 zum Zweck der Hutschienenmontage der Überspannungsschutzanordnung vorgesehen.

Eine erste Ebene am balkenförmigen Grundkörper 1 wird als horizontale Ebene 4 und eine zweite Ebene als horizontale Ebene 5 bezeichnet. Sowohl auf der horizontalen Ebene 4 sind elektrische Anschlussmittel 6 als auch auf der vertikalen Ebene 5 elektrische Anschlussmittel 7 zugänglich bzw. angeordnet.

Bei einer bevorzugten Ausführungsform sind die ersten Anschlussmittel 6 als Klemmen zum Drahtanschluss ausgebildet. Die horizontale Ebene 4 ist geneigt, d.h. als Schrägfläche ausgebildet, so dass eine optimale Einführung von Anschlussleitungen möglich ist und die Anschlussleitungen Platz unter einer nicht gezeigten Verteilerabdeckung finden.

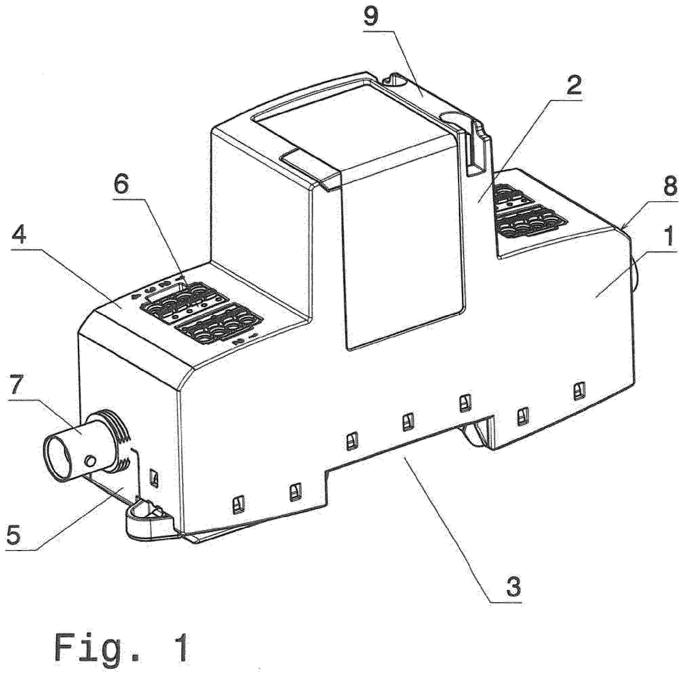

In der vertikalen Ebene 5 (Ebene 2) können z.B. Buchsen oder Stecker angeordnet sein. Die Darstellung nach Fig. 1 zeigt als Anschlussmittel 7 eine BNC-Buchse. Weitere Ausführungen können als RJ-Buchsen, Sub-D-Steckerbuchsen oder dergleichen vorgesehen sein.

Die vorerwähnte Schrägfläche ist in der Fig. 1 mit dem Bezugszeichen 8 symbolisiert.

Eine weitere Ebene 9 (Ebene 3) dient der im Folgenden noch beschriebenen Anordnung einer Klemme in Ausrichtung zum Nachbargerät beim Aneinanderreihen verschiedener Überspannungsschutzanordnungen, z.B. zur Durchverbindung einer Bus-/Kommunikationsleitung für den Datenaustausch zwischen entsprechend nebeneinander befindlichen Geräten.

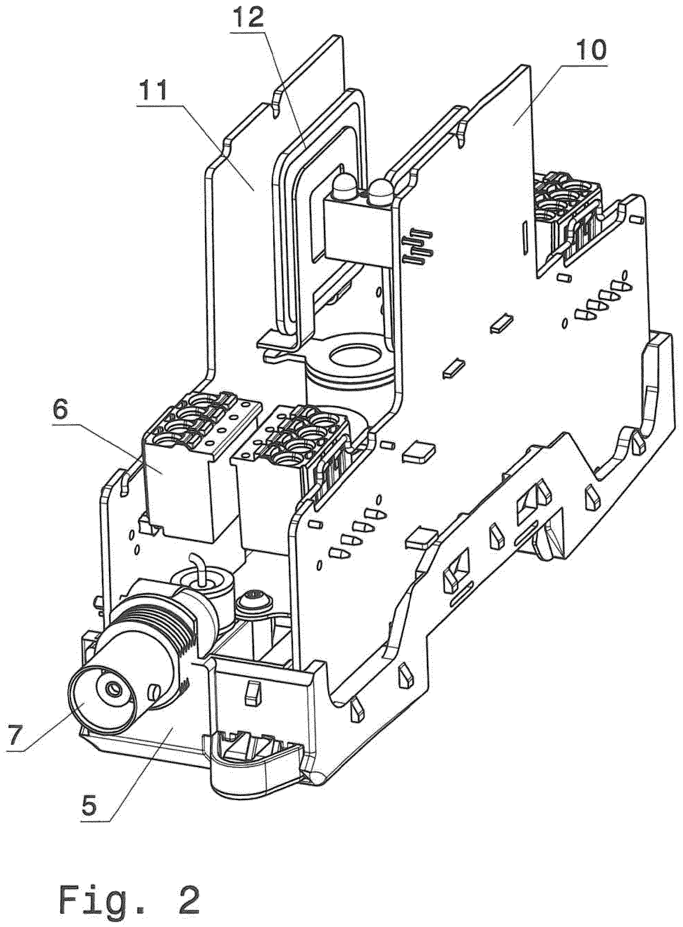

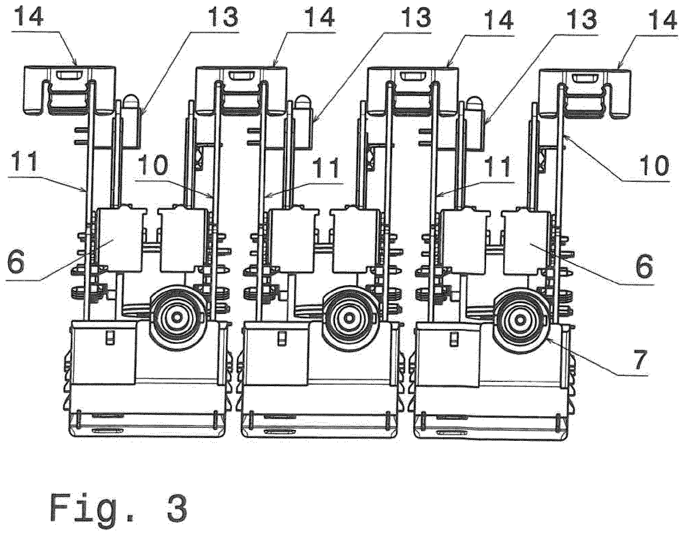

Die Darstellungen nach den Fig. 2 und 3 zeigen, dass innerhalb des Gehäuses zwei beabstandete Leiterplatten 10 und 11 angeordnet sind, die eine Flächenform aufweisen, die im Wesentlichen der Längsschnittfläche des Gehäuses entspricht. Im Raum zwischen den Leiterplatten 10 und 11 sind z.B. jeweils Klemmen 6 für den Drahtanschluss bzw. ein Stecker / eine Buchse 7 zum Anschluss eines Koaxialleiters befindlich. Die Leiterplatten tragen darüber hinaus die eigentlichen Überspannungsschutzelemente 12, z.B. Varistoren, und dienen dem Fixieren von Funktionsanzeigen 13, z.B. ausgebildet als lichtemittierende Dioden.

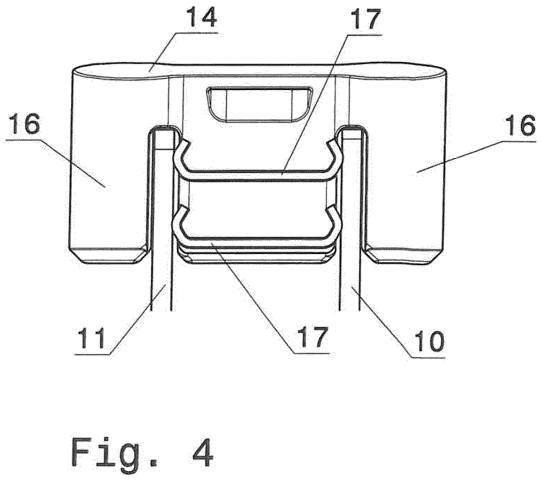

Wie aus den Fig. 3 und 4 ersichtlich, kann durch die Anordnung der Leiterplatten 10; 11 seitlich an der jeweiligen Gehäuseinnenwandung über einen Leiterplatten-Steckverbinder 14 eine elektrische Verbindung zwischen benachbarten Geräten hergestellt werden, um einen Datenaustausch zu realisieren oder aber auch eine Stromversorgung zu ermöglichen.

Das Steckelement 14 kann, wie in Fig. 4 deutlich wird, als Formteil ausgeführt werden, welches auf die Öffnungskontur im Kopfteil 9 des Gehäuses befindliche Öffnung 15 angepasste Fortsätze 16 aufweist.

Ist z.B. das Steckelement 14 mit einer leitfähigen Kontur oder einem leitfähigen Abschnitt 17 versehen, kann die gewünschte elektrische Verbindung zwischen den Leiterplatten 10 und 11 realisiert werden.

Beim gezeigten Beispiel besteht das Steckelement 14 aus den zwei stiftförmigen Fortsätzen 16, die über einen Steg verbunden sind. Die jeweilige Öffnung 15 im Kopfteil 9 des entsprechenden Gehäuses ist dieser Steckelemente-Kontur entsprechend angepasst.

Der Verbinder ist demnach so ausführbar, dass über die Kontur des Steckelements und der komplementären Ausbildung als Gehäusekontur gleichzeitig eine mechanische Verrastung zwischen benachbarten Geräten erfolgt. Hierdurch wird eine Verbesserung der Stabilität der Gesamtanordnung erreicht. Nach Abziehen des Steckelements bzw. der entsprechenden Steckelemente 14 kann ein entsprechendes Gerät aus dem Verband herausgelöst werden. Ein Lösen von Drähten oder Kabeln ist insofern nicht erforderlich.

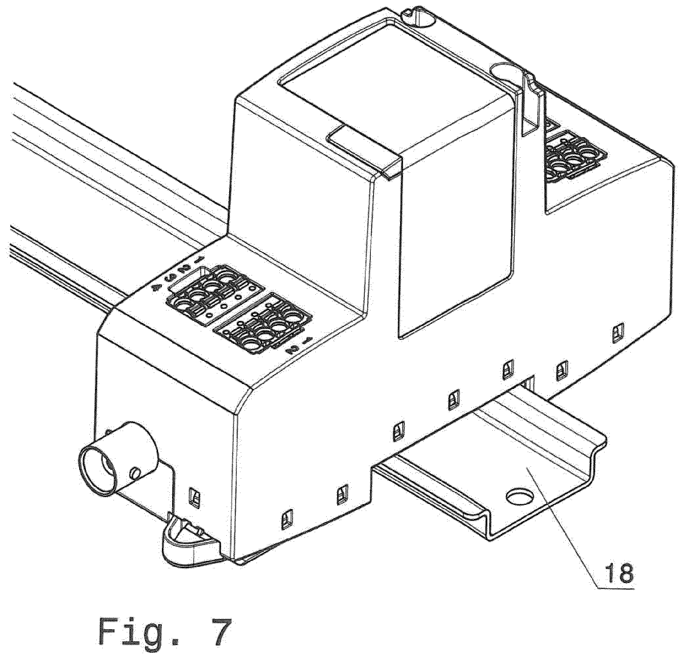

Die Fig. 7 zeigt eine erfindungsgemäße Überspannungsschutzanordnung mit teilweggebrochenem Gehäuse, angeordnet auf einer Hutschiene 18. Zur Kontaktierung mit der Hutschiene besteht die Möglichkeit, die Leiterplatten 10; 11 über ein Kontaktelement 19 mechanisch zu verbinden und elektrisch zu kontaktieren.

Insofern ist im Unterteil des Gehäuses das erwähnte Kontaktelement 19 vorgesehen, welches die Leiterplatten 10 und 11 mit der Hutschiene 18 verbindet. Ergänzend wird mit Blick auf dieses Lösungselement eine gute mechanische Festigkeit der Leiterplatten im Gehäuse mit Sitz auf der Hutschiene 18 erreicht. Über Rastelemente 20 am Kontaktelement 19 kann die Anordnung im Gehäuseunterteil fixiert werden.

## Patentansprüche

1. Überspannungsschutzanordnung für die Informations- und Telekommunikationstechnik, bestehend aus einem Gehäuse mit am Gehäuseboden ausgebildeten Mitteln (3) zur Hutschienenmontage, im Gehäuse befindlichen Überspannungsschutzelementen (12), elektrischen Anschlussmitteln (6; 7) sowie Leiterplatten (10; 11) als Verdrahtungsträger für die Überspannungsschutzelemente (12), weiterhin mit einer Gestalt des Gehäuses mit einem balkenförmigen Grundkörper (1) und einem hervorspringenden Kopfteil (2), wobei
eine erste (10) und eine zweite (11) Leiterplatte voneinander beabstandet jeweils an den Innenseiten der Seitenwände des Gehäuses befindlich sind und im Abstandsraum die elektrischen Anschlussmittel (6; 7) in Form von elektrischen Anschlussklemmen, Anschlussbuchsen und/oder Steckern angeordnet sind derart, dass erste Anschlussmittel (6) in horizontaler (4) und zweite Anschlussmittel (7) in vertikaler (5) Ebene des balkenförmigen Grundkörpers (1) zugänglich sind, sowie die Flächenform der Leiterplatten (10; 11) der Form des Gehäuses angenähert ist oder dieser Form entspricht, **dadurch gekennzeichnet, dass**
die ersten Anschlussmittel (6) als auf der Leiterplatte fixierte, verriegelbare Buchsenleisten zum Klemmen von Drähten ausgeführt sind.

2. Überspannungsschutzanordnung nach Anspruch 1,
**dadurch gekennzeichnet, dass**
die zweiten Anschlussmittel (7) als koaxiale Stecker oder Buchsen ausgeführt sind.

3. Überspannungsschutzanordnung nach einem der vorangegangenen Ansprüche,
**dadurch gekennzeichnet, dass**
die horizontale Ebene (4) des balkenförmigen Grundkörpers als Schrägfläche (8) zur abgewinkelten Führung und Aufnahme von Anschlussdrähten bei Anordnung des Überspannungsschutzgeräts unter einer Verteilerabdeckung ausgebildet ist.

4. Überspannungsschutzanordnung nach einem der vorangegangenen Ansprüche,
**dadurch gekennzeichnet, dass**
diese aneinanderreihbar ausgebildet ist.

5. Überspannungsschutzanordnung nach Anspruch 4,
**dadurch gekennzeichnet, dass**
am Kopfteil (2) des Gehäuses jeweils im Bereich der Leiterplatten (10; 11) eine verschließbare Öffnung (15) vorgesehen ist, welche Zugang zu einem Leiterplattenabschnitt gewährt.

6. Überspannungsschutzanordnung nach Anspruch 5,
**dadurch gekennzeichnet, dass**
bei mindestens zwei aneinandergereihten Überspannungsschutzgeräten mittels der Öffnungen (15) ein Steckelement (14) anbringbar ist, welches die jeweiligen Geräte mechanisch und/oder elektrisch verbindet.

7. Überspannungsschutzanordnung nach Anspruch 6,
**dadurch gekennzeichnet, dass**
das Steckelement (14) als Formteil ausgeführt ist, welches auf die Öffnungskontur abgestellte, dieser komplementäre Fortsätze (16) aufweist.

8. Überspannungsschutzanordnung nach Anspruch 6 oder 7,
**dadurch gekennzeichnet, dass**
das Steckelement (14) leitfähig ist oder einen leitfähigen Abschnitt (17) besitzt.

9. Überspannungsschutzanordnung nach einem der Ansprüche 6 bis 8,
**dadurch gekennzeichnet, dass**
das Steckelement (14) als elektrische Verbindungsbrücke ausgeführt ist.

10. Überspannungsschutzanordnung nach einem der vorangegangenen Ansprüche,
**dadurch gekennzeichnet, dass**
im Bereich der dem Gehäuseboden zugewandten Enden der Leiterplatten (10; 11) diese über ein gemeinsames Kontaktelement (19) verbunden sind, wobei über das gemeinsame Kontaktelement (19) die Verbindung zur Hutschiene (18) herstellbar ist.

## Claims

1. An overvoltage protection arrangement for information and telecommunications technology, composed of a housing having means (3) for top hat rail installation formed on the housing bottom, overvoltage protection elements (12) located within the housing, electrical connection means (6; 7) as well as circuit boards (10; 11) as wiring carriers for the overvoltage protection elements (12), furthermore having a configuration of the housing with a beam-shaped basic body (1) and a projecting head member (2), wherein
a first (10) and a second (11) circuit board each are located spaced from one another at the inner sides of the sidewalls of the housing, and in the spacing area, the electrical connection means (6; 7) in the form of electrical connecting terminals, connecting sockets and/or plugs are arranged such that first connection means (6) are accessible in a horizontal (4) plane and second connection means (7) in a vertical (5) plane of the beams-shaped basic body (1), and the surface shape of the circuit boards (10; 11) is approximated to shape of the housing or corresponds to said shape,
**characterized in that**
the first connection means (6) are realized as lockable socket connector strips fixed to the circuit board for clamping wires.

2. The overvoltage protection arrangement according to claim 1,
**characterized in that**
the second connection means (7) are realized as coaxial connectors or sockets.

3. The overvoltage protection arrangement according to any one of the preceding claims,
**characterized in that**
the horizontal plane (4) of the beam-shaped basic body is formed as an oblique surface (8) for an angled guidance and reception of connection wires with arranging the overvoltage protection device under a distributor cover.

4. The overvoltage protection arrangement according to any one of the preceding claims,
**characterized in that**
it is formed to be able to be arranged in a row.

5. The overvoltage protection arrangement according to claim 4,
**characterized in that**
at the head member (2) of the housing in each case in the area of the circuit boards (10; 11), a closable opening (15) is provided giving access to a circuit board section.

6. The overvoltage protection arrangement according to claim 5,
**characterized in that**
in the case of at least two overvoltage protection devices arranged in a row, a plug-in element (14) may be attached by means of the openings (15), which connects the respective devices mechanically and/or electrically.

7. The overvoltage protection arrangement according to claim 6,
**characterized in that**
the plug-in element (14) is realized as a molded part which includes projections (16) matched to the contour of the openings to be complementary to it.

8. The overvoltage protection arrangement according to claim 6 or 7,
**characterized in that**
the plug-in element (14) is conductive or has a conductive section (17).

9. The overvoltage protection arrangement according to any one of claims 6 to 8,
**characterized in that**
the plug-in element (14) is realized as an electrical connecting bridge.

10. The overvoltage protection arrangement according to any one of the preceding claims,
**characterized in that**
in the area of the ends of the circuit boards (10; 11) facing the housing bottom, said ends are connected via a common contact element (19), wherein the connection to the top hat rail (18) may be established via the common contact element (19).

## Revendications

1. Agencement de protection contre les surtensions pour les technologies de l'information et des télécommunications, constitué d'un boîtier ayant des moyens (3) destinés au montage sur un rail oméga et réalisés au fond du boîtier, des éléments (12) de protection contre les surtensions situés dans le boîtier, des moyens de connexion électrique (6 ; 7) ainsi que des cartes à circuit imprimé (10 ; 11) faisant office de supports de câblage pour les éléments (12) de protection contre les surtensions, le boîtier ayant en outre la configuration d'un corps de base (1) en forme de parallélépipède et une partie de tête en saillie (2),
dans lequel
une première (10) et une deuxième (11) carte à circuit imprimé sont situées à distance l'une de l'autre, chacune sur les faces intérieures des parois latérales du boîtier, et les moyens de connexion électrique (6 ; 7) sous la forme de bornes de connexion électrique, de fiches femelles de connexion et/ou de fiches mâles de connexion sont disposés dans l'espacement de telle sorte que les premiers moyens de connexion (6) sont accessibles dans le plan horizontal (4) et les deuxièmes moyens de connexion (7) sont accessibles dans le plan vertical (5) du corps de base (1) en forme de parallélépipède, et la forme surfacique des cartes à circuit imprimé (10 ; 11) s'approche de la forme du boîtier ou correspond à cette forme,
**caractérisé en ce que**
les premiers moyens de connexion (6) sont réalisés sous forme de barrettes à fiches femelles verrouillables fixées sur la carte à circuit imprimé pour serrer des fils.

2. Agencement de protection contre les surtensions selon la revendication 1,
**caractérisé en ce que**
les seconds moyens de connexion (7) sont réalisés sous forme de fiches mâles ou de fiches femelles coaxiales.

3. Agencement de protection contre les surtensions selon l'une des revendications précédentes,
**caractérisé en ce que**
le plan horizontal (4) du corps de base en forme de parallélépipède est réalisé sous forme de surface inclinée (8) pour le guidage et la réception en angle des fils de connexion lorsque le dispositif de protection contre les surtensions est disposé sous un couvercle de distribution.

4. Agencement de protection contre les surtensions selon l'une des revendications précédentes,
**caractérisé en ce que**
celui-ci est réalisé de manière à pouvoir être disposé en rangées.

5. Agencement de protection contre les surtensions selon la revendication 4,
**caractérisé en ce que**
une ouverture (15) pouvant être fermée est prévue sur la partie de tête (2) du boîtier dans la zone des cartes à circuit imprimé (10 ; 11) respectives, permettant d'accéder à une portion de la carte à circuit imprimé.

6. Agencement de protection contre les surtensions selon la revendication 5,
**caractérisé en ce que**
si au moins deux dispositifs de protection contre les surtensions sont disposés en rangée, il est possible de fixer un élément enfichable (14) par les ouvertures (15), qui relie mécaniquement et/ou électriquement les dispositifs respectifs.

7. Agencement de protection contre les surtensions selon la revendication 6,
**caractérisé en ce que**
l'élément enfichable (14) est réalisé sous forme de pièce moulée ayant des prolongements (16) qui sont adaptées au contour de l'ouverture et qui sont complémentaires à celui-ci.

8. Agencement de protection contre les surtensions selon la revendication 6 ou 7,
**caractérisé en ce que**
l'élément enfichable (14) est conducteur ou possède une portion conductrice (17).

9. Agencement de protection contre les surtensions selon l'une des revendications 6 à 8,
**caractérisé en ce que**
l'élément enfichable (14) est réalisé sous forme de pont de connexion électrique.

10. Agencement de protection contre les surtensions selon l'une des revendications précédentes,
**caractérisé en ce que**
dans la zone des extrémités des cartes à circuit imprimé (10 ; 11) tournées vers le fond du boîtier, celles-ci sont reliées par un élément de contact commun (19), la connexion avec le rail oméga (18) pouvant être établie par l'intermédiaire de l'élément de contact commun (19).
